Europäisches Patentamt

European Patent Office

Office européen des brevets

(11) Publication number: **0 107 318**
**B1**

(12) **EUROPEAN PATENT SPECIFICATION**

(45) Date of publication of patent specification: 26.08.87

(21) Application number: 83305348.1

(22) Date of filing: 13.09.83

(51) Int. Cl.⁴: **H 01 H 57/00,** H 03 K 17/96, H 03 M 11/00

(54) Solid state keyboard.

(30) Priority: 13.09.82 US 417524
12.11.82 US 441380

(43) Date of publication of application:
02.05.84 Bulletin 84/18

(45) Publication of the grant of the patent:
26.08.87 Bulletin 87/35

(84) Designated Contracting States:
CH DE FR GB IT LI SE

(56) References cited:
WO-A-81/02223
DE-A-2 064 657
DE-A-2 318 211
DE-A-3 126 340
DE-B-2 444 220
DE-B-2 915 410

The file contains technical information
submitted after the application was filed and
not included in this specification

(73) Proprietor: KDC CORPORATION
1055 Cindy Lane
Carpinteria California 93013 (US)

(72) Inventor: Kompanek, Harry W.
153 Ramelto Road Santa Barbara
California 93108 (US)
Inventor: Ming, Rickey H.
1300 Saratoga Apt No 1504
Ventural California 93003 (US)
Inventor: Ligman, James R.
910 St. Vincent Avenue
Santa Barbara California 93101 (US)

(74) Representative: Baillie, Iain Cameron et al
c/o Ladas & Parry Isartorplatz 5
D-8000 München 2 (DE)

(56) References cited:
DE-B-2 915 456
GB-A-1 573 394
US-A-3 386 067
US-A-4 158 117
US-A-4 234 813

Courier Press, Leamington Spa, England.

(56) References cited:
**BAUTEILE REPORT, Band 14, Heft 4, 1976,
Siemens AG, München; GOERNE "Piezotaste
für wegloses Schalten" pages 124-126**

**ELEKTRONIKER, Nr.1/1976, Aarau
"Piezoelectric push-button" pages 45-46**

**ELEKTRONIK, Heft 3, 1978, München,
SCHMIDT "Neuartige Kontaktauslösung mit
elektronischen Tasten" pages 83-84**

## Description

Technical Field

This invention relates to keyboards and more particularly relates to keyboards for converting individual actuations of keys to electrical signals indicating the actuation of such keys. The invention especially relates to keyboards employing piezoelectric crystals to obtain the production of such electrical signals.

Background of the Invention

Keyboards are now in use for a wide variety of purposes. For example, keyboards have been included in typewriters for a considerable number of decades to provide documentary records of the information typed and are still in use for such purposes. Keyboards have also been used for the past several decades to provide messages for data processing purposes. For example, the messages typed on the keyboard represent data which are processed by data processing equipment to generate new or updated data.

The keyboards now in use generally have certain limitations. They generally include keys with movable parts. When the key is actuated, the parts are moved to provide an indication of the symbol represented by the key. These parts tend to become worn with continued use. When the parts become sufficiently worn, they operate inadequately and cause incorrect, or at least incomplete information to be generated.

Another problem with typewriter keyboards now in use is that they require power supplies in order to convert mechanical forces to electrical signals. These power supplies tend to increase the size, cost and weight of the typewriter keyboards. Since these factors are important from psychological and competitive standpoints, the provision of a keyboard operative to generate electrical signals without the use of a power supply would provide an important advantage from a competitive and psychological standpoint.

Since equipment employing keyboards is in widespread use, considerable effort and money have been expended in developing a keyboard which will operate without any mechanical parts and without any power supplies. Considerable effort and money have also been expended in providing a keyboard which is compact, sensitive and reliable. In spite of such efforts, the problems discussed above still exist in keyboards.

It is known to use piezoelectric devices in keyboards and switches in general. See for example documents US—A—4 234 813 and DE—A—20 64 657. In US—A—4 234 813 a keyboard is formed using a sheet of piezoelectric polymeric material sandwiched between perpendicularly disposed sets of electrodes. Each crossing point of an electrode on one side of the sheet with an electrode on the other side forms a key position and is aligned with an aperture in a keyboard defining plate that covers the entire electrode and sheet sandwich. The individual key positions may be activated by pressure in the appropriate aperture and for this purpose a hammer mechanism operated by a conventional key - is disclosed. Document DE—A—20 64 657 discloses a single key of a keyboard and associated circuitry to detect signals produced by a piezoelectric crystal within the key pad. The arrangement of this document claims to require no mechanical movement and this is a property inherent in the use of a piezoelectric device.

According to the present invention, however, there is provided a keyboard using a crystal as the transducer and which overcomes the disadvantages inherent in the systems discussed above. The keyboard comprises a housing; a thin sheet of an electrically insulating material disposed next to said housing; a thin sheet of an electrically conductive member adhered to the thin sheet of electrically insulating material; and a ceramic crystal having a first surface attached to the thin sheet of the electrically conductive member in an electrically conductive relationship with the member and constructed to be strained and to produce an electrical signal when strained, and the keyboard is characterized in that the housing is constructed to define a particular area depressible to identify an individual inicium, the thin sheet of the electrically insulating material is adhered to the housing by a hard electrically insulating material at a position corresponding to the particular area in the housing and constructed to transmit strains produced in the housing by the depression of the particular area in the housing and in that the thin sheet of the electrically conductive member is adhered to the thin sheet of electrically insulating material at a position corresponding to the particular area in the housing and constructed to transmit strains produced in the housing by the depression of the housing at the particular area in the housing. Particular preferred embodiments of the invention are defined in claims 2 to 18 below.

A keyboard embodying the present invention will now be described by way of example only making reference to the accompanying drawings in which:

Figure 1 is a perspective view of a keyboard viewed from a position in front, and to one side of the keyboard;

Figure 2 is a perspective view of the keyboard shown in Figure 1; as seen from a position to the rear and to one side of the keyboard;

Figure 3 is an enlarged elevational view, in exploded sections of the keyboard shown in Figures 1 and 2; and

Figure 4 is an enlarged exploded fragmentary view in perspective of certain elements included in the keyboard shown in the previous Figures.

Figure 5 is a schematic diagram of an electrical system which may be used with the keyboard shown in Figures 1 through 4 to produce usable signals at low impedances; and

Figure 6 is a schematic diagram of another electrical system which may be used with the typewriter keyboard shown in Figures 1 through 4 to produce usable signals at low impedances.

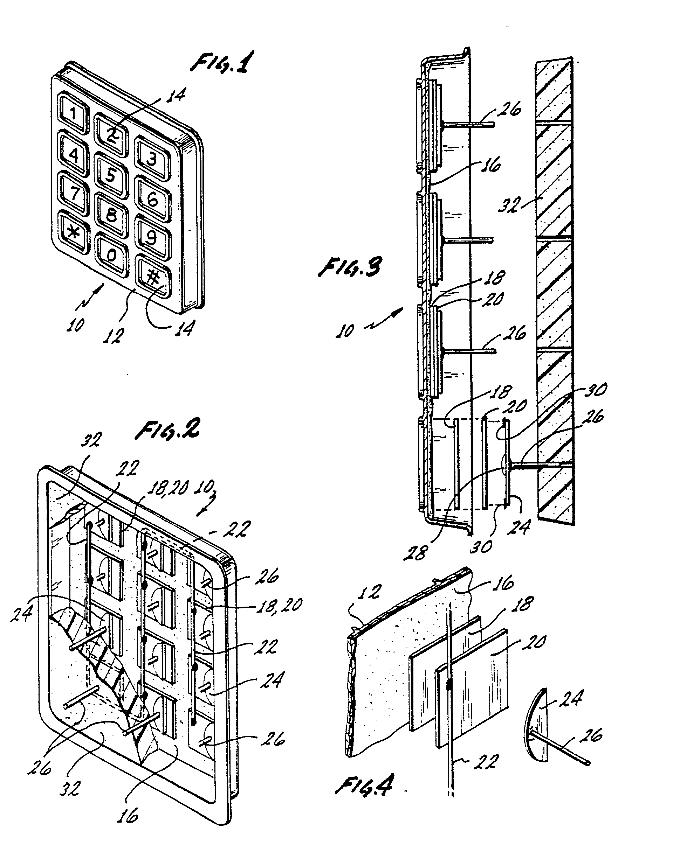

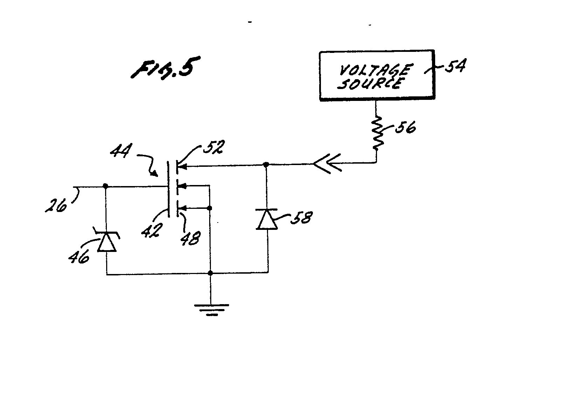

In Figure 1 a keyboard generally indicated at 10 is provided. The keyboard includes a housing 12 preferably made from an electrically conductive material such as a stainless steel or anodized aluminum. The housing 12 is preferably made from a sheet material about one-half mm (0.020 inch) thick but the thickness may be any suitable value such as in the range of 0.25 mm (0.010 inch) to 1.53 mm (0.060 inch).

The housing is provided with different areas 14 which are depressed to identify individual indicia. For example, these areas may represent different numerals or different letters of the alphabet. When the different areas 14 are depressed, forces are created in these areas and these forces are used to generate electrical signals. The individual areas 14 on the housing can be considered to be the keys of the keyboard 10.

A suitable material such as an epoxy 16 is adhered to the housing 12 and is provided with characteristics to transmit the force or stress imposed on the different keyboard areas 14 when these areas are depressed. The epoxy 16 is provided with a relatively high durometer such as a durometer (Shore D hardness) of 96 but may be provided with any suitable durometer such as in a range of 70 to 98. The epoxy is preferably an Emerson & Cumming Number 2850 epoxy with a catalyst No. 11 to provide for a fast drying.

Preferably the epoxy 16 is heavily filled and mixed with a ceramic powder made from a suitable material such as aluminum oxide. The ceramic-filled epoxy is provided with characteristics so that it will not produce voids when it is applied to the housing. Voids are undesirable since they inhibit the transmission of the forces applied to the different keyboard areas 14 on the housing 12. The ceramic-filled epoxy 16 is preferably applied to the housing 12 in a thickness in the order of quarters of a milimeter (tens of thousandths of an inch).

Sheets 18 of backing material made from a suitable electrically insulating material such as fiberglass are adhered to the epoxy 16 at positions adjacent the keyboard areas 14. The insulating sheets 18 are preferably provided with a suitable thickness such as 0.75 mm (0.030 inch). However, the sheets 18 can have any suitable thickness such as a thickness in the order of 0.38 mm (0.015 inch) to 1.53 mm (0.060 inch).

A thin sheet 20 of an electrically conductive material is adhered in a conventional manner to each of the insulating sheets 18. For example, the sheets 20 may be made from a suitable material such as copper. The sheets 20 are preferably provided with a suitable thickness such as 0.127 mm (0.005 inch), or even less, but thicknesses as high as 1.53 mm (0.060 inch) are satisfactory. The insulating sheets 18 and the conductive sheets 20 may constitute segments of a thin printed circuit board. The sheets 20 are preferably grounded to one another and to the housing 12 by a wire 22 attached as by solder to the sheets 20 and the housing.

Crystals 24 made from a suitable material such as a ceramic are included, each being attached to an individual one of the conductive sheets 20. The crystals 22 are preferably piezoelectric and polarized. The crystals 22 are preferably made from a mixture of lead zirconate and lead titanate in a particular proportion such as approximately fifty-two percent (52%) lead zirconate and approximately forty-eight percent (48%) lead titanate by weight. A suitable material such as niobium oxide or columbium oxide is preferably included in the mixture in a relatively small amount such as approximately eight-tenths of a percent (0.8%) by weight. The niobium oxide or columbium oxide increases the dielectric constant and the piezoelectric constants of the crystals 24. A very small amount of lanthanum oxide may also be included in the mixture. The crystals may be equivalent to those designated as PZT 5, which has a dielectric constant of at least 1700 and a Curie point of approximately 330°C.

The crystals 24 may be provided with a suitable thickness such as approximately 0.25 mm (0.010 inch). However, the crystals 24 may be provided with a suitable thickness in a range of approximately 0.17 mm (0.007 inch) to approximately 0.50 mm (0.020 inch). Electrical leads 26 may be included, each being attached to the ungrounded surface of an individual one of the crystals 24. The leads 26 may introduce electrical signals from the crystals 24 to associated apparatus (not shown).

The crystals 24 are adhered to the conductive sheets 20 by a suitable material 28 preferably having electrically conductive properties. For example, a suitable epoxy such as that designated as 60L by Emerson & Cumming of Canton, Massachusetts, is mixed with a graphite powder to make it conductive and may be applied in a small dab to the central area of each crystal 24. Each crystal 24 may then be adhered to an associated one of the conductive sheets 20. A small amount 30 of the same epoxy as the epoxy 16 may then be applied around the periphery of each of the crystals 24.

A suitable covering 32 may be applied over the crystals 24 and the conductive sheets 20 and even the epoxy 16. The covering 32 may be a suitable material such as an epoxy with a durometer (Shore D hardness) of approximately 90. A relatively small amount of particles of a suitable material such as chromium oxide may be mixed in the epoxy to increase the durometer of the epoxy and to provide it with a distinctive color such as green. For example, approximately 25g to 50g of chromium oxide may be mixed with 450g of epoxy.

When individual ones of the keyboard areas 14 are depressed, the resultant forces are transmitted through the epoxy 16 to the crystals 24. The crystals then become strained to produce signals on the ungrounded terminals of the crystals. These signals have relatively large amplitudes. For example, the signals may have amplitudes of approximately four (4) or five (5) volts. These signals may then be used to operate associated apparatus (not shown).

The keyboard described above has certain important advantages. It converts depressions of the keyboard area 14 to the generation of electrical signals by the crystals 24 without any moving parts and without the inclusion of an energy source such as a battery. Furthermore, it provides for the generation of signals of large amplitudes by the crystals 24 by providing for an efficient transmission of forces from the keyboard 12 through the epoxy coating 16 and the epoxy covering 32. The keyboard is accordingly sensitive, reliable, small and long-lived.

The insulating material 32 may also constitute an epoxy having a durometer (Shore D hardness) less than about sixty (60). Preferably such an epoxy has relatively flexible characteristics. An epoxy with these characteristics is desirable because it tends to minimize the generation of noise in the signals produced by the crystals 24. For example, an epoxy designated as DC 23 by Thermoset Inc. has been found to be satisfactory.

Other materials than an epoxy have been found to be satisfactory for the layer 32. For example, a polyurethane having a durometer in the range of about fifty (50) to ninety-five (95) may also be used. By way of illustration, a polyurethane designated as 1547 by Products Research Corporation has been found to be satisfactory.

When individual ones of the keyboard areas 14 are depressed, the resultant forces are transmitted through the epoxy 16 to the crystals 24. The crystals then become strained to produce signals on the ungrounded terminals of the crystals.

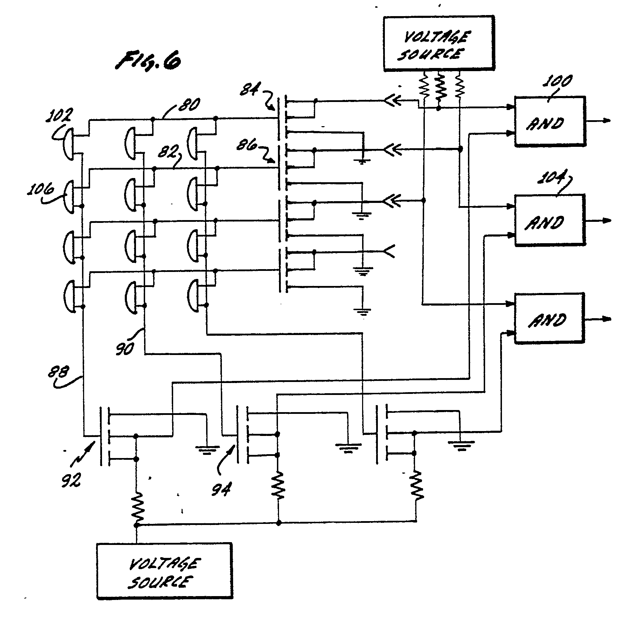

These signals have relatively large amplitudes. For example, the signals may have amplitudes of approximately four (4) or five (5) volts. These signals may then be used to operate the associated apparatus shown in Figures 5 and 6.

When an insulating layer 32 made from a material such as DC—23 of Thermoset, Inc. is used, a signal having a relatively high impedance and having a voltage in the order of four (4) to five (5) volts is generated by each crystal 24 when the crystal becomes strained. This voltage from each crystal 24 is introduced to an electrode 42 (Figure 5) of a control member such as a semi-conductor, generally indicated at 44, associated with the crystal. The semi-conductor 44 is preferably a field effect transistor and the electrode 42 may be the gate electrode of the transistor. A zener diode 46 is connected between the gate electrode 42 and a reference potential such as ground.

A second electrode 48 such as the source of the field effect transistor has a common connection with the reference potential such as ground. A third electrode 52 such as the drain of the field effect transistor receives voltage from a source 54. A resistance 56 may be included in the line between the source 54 and the electrode 52 to limit the current flowing through the semi-conductor 44. A diode 58 is connected between the electrodes 42 and 52 with the anode of the diode common with the electrode 42 and the cathode of the diode common with the electrode 52.

When the crystal 24 becomes strained, it introduces a signal to the gate electrode 42 of the field effect transistor 44, which is normally biased to a state of non-conductivity. This causes the field effect transistor to become conductive when the transistor is a P channel transistor such as shown in Figure 5. The resultant flow of current through a circuit including the voltage source 54, the resistance 56 and the transistor 42 causes the voltage on the drain of the transistor to decrease toward ground. The resultant negative signal on the drain 52 is used to control the operation of output equipment (not shown) such as data processing equipment. The signals produced by the transistors such as the transistors 44 are large in amplitude and are provided with a relatively low impedance so that they can be introduced directly to the output equipment such as the data processing equipment. By way of illustration, the transistor 44 may have an impedance as low as one (1) ohm when it is conductive.

Figure 6 illustrates another electrical system for producing electrical signals in accordance with the operation of the keyboard. In the embodiment of the electrical system shown in Figure 6, rows of the ungrounded terminals of the crystals are connected by a common line. For example, the row of crystals is connected by a line 80 and the next row is connected by a line 82. The line 80 is connected to a P channel field effect transistor, generally indicated at 84, in a manner similar to that shown in Figure 5. The line 82 is connected to a P channel field effect transistor, generally indicated at 86, in a similar manner.

Each column of the crystals has a common line in Figure 6 on the ungrounded terminal of the crystals. For example, the first column of the crystals has a common line 88 and the second column of the crystals has a common line 90. The lines 88 and 90 are connected to the crystals at different positions on the crystals than the connections to the lines 80 and 82 so that the lines 80 and 82 will be electrically isolated.

Each line, such as the line 88 and the line 90, is connected to the gate electrode of an individual P channel transistor. For example, the line 88 is connected to the gate of a P channel transistor generally indicated at 92, and the line 90 is connected to the gate electrode of a P channel transistor generally indicated at 94. The drain of each of the transistors such as the transistors 92 and 94 is connected to a reference potential such as ground and an energizing potential is introduced to the source of each such electrode.

The signals on the drain of the transistor 84 and on the source of the transistor 90 are introduced to the input terminals of "and" gate 100. A signal is accordingly produced on the output terminal of the "and" gate 100 when a crystal 102 common to the top row and the first column in the keyboard is stressed. Similarly, an "and" network 104 has input terminals connected to the drain of the transistor 84 and the source of the transistor 92. As a result, an output signal is produced by the "and" network 104 when a crystal 106 common to the second row and the first column in the keyboard is stressed. Similarly, other "and" networks may be connected to transistors individual to a particular row and particular column of crystals to produce output signals in accordance with the stressing of an individual one of the keys in the keyboard.

The keyboard described above has certain important advantages. It converts depressions of the keyboard area 14 to the generation of electrical signals by the crystals 24 without any moving parts and without the inclusion of an energy source such as a battery. Furthermore, it provides for the generation of signals of large amplitudes by the crystals 24 by providing for an efficient transmission of forces from the keyboard 12 through the epoxy coating 16 and the epoxy covering 40. These signals are produced with a minimal amount of noise regardless of the amount of noise produced in the signals from the crystals. The keyboard is accordingly sensitive, reliable, small and long-lived.

The invention also embraces embodiments including in addition electrical systems associated with the keyboard. These electrical systems operate to provide electrical signals, in accordance with the stresses imposed upon the crystals, which have a high amplitude and a low impedance. The output equipment (not shown) responsive to the operation of the keyboard is accordingly able to operate efficiently because of the introduction of signals having a relatively high amplitude, low noise and an impedance effectively matching the input impedance of the output equipment.

## Claims

1. A keyboard comprising:
a housing (12);
a thin sheet of an electrically insulating material (18) disposed next to said housing (12);
a thin sheet of an electrically conductive member (20) adhered to the thin sheet of electrically insulating material (18); and
a ceramic crystal (24) having a first surface attached to the thin sheet of the electrically conductive member (20) in an electrically conductive relationship with the member (20) and constructed to be strained and to produce an electrical signal when strained, and characterized in that the housing (12) is constructed to define a particular area (14) depressible to identify an individual indicium, the thin sheet of the electrically insulating material (18) is adhered to the housing (12) by a hard electrically insulating material (16) at a position corresponding to the particular area (14) in the housing (12) and constructed to transmit strains produced in the housing (12) by the depression of the particular area (14) in the housing (12) and in that the thin sheet of the electrically conductive member (20) is adhered to the thin sheet of electrically insulating material (18) at a position corresponding to the particular area (14) in the housing (12) and constructed to transmit strains produced in the housing (12) by the depression of the housing (12) at the particular area (14) in the housing.

2. A keyboard according to claim 1, wherein the ceramic crystal (24) has a second surface opposite to the first surface, and there is
means (26) providing an electrical connection to the second surface of the crystal to receive the electrical signals on the second surface of the crystal (24).

3. A keyboard according to claim 1 or 2, wherein
the housing (12) is electrically conductive, and there is provided
the means (22) defining the ground plane attached to the housing (12) to ground the ground plane to the housing.

4. A keyboard according to any preceding claim, wherein the crystal has a second surface opposite to the first surface, the second surface of the crystal being ungrounded, and there is
an insulating coating over the second surface of the crystal.

5. A keyboard according to any preceding claim, wherein the thin sheet of the electrically insulating material (18) and the thin sheet of the electrically conductive member (20) constitute a printed circuit.

6. A keyboard according to any preceding claim, wherein the thin sheet of electrically insulating material (18) is disposed closer to the housing (12) than the thin sheet of electrically conductive material (20) and being disposed even closer to the housing (12) than the crystal (24).

7. A keyboard according to any preceding claim, wherein the hard electrically insulating material (16) has a durometer reading (Shore D hardness) of at least 70.

8. A keyboard according to any preceding claim, wherein the hard electrically insulating material (16) is formed from an epoxy mixed with particles of a filler to inhibit the formation of voids.

9. A keyboard according to any preceding claim, wherein an epoxy adhesive adheres the thin sheet of the electrically conductive member (20) to the first surface of the crystal and includes particles of an electrically conductive material in the epoxy adhesive to ground electrically the first surface of the crystal.

10. A keyboard according to any preceding claim, wherein the housing (12), the hard electrically insulating material (16), the thin sheet of electrically insulating material (18), the thin sheet of the electrically conductive member (20) and the crystal (24) are disposed in abutting relationship to one another without any voids.

11. A keyboard according to any preceding claim, wherein an insulating covering (32) is adhered to the second surface of the crystal.

12. A keyboard according to claim 11, wherein the insulating covering (32) has a durometer reading (Shore D hardness) of approximately 90.

13. A keyboard according to any preceding claim, wherein the hard insulating material (18) has a durometer reading (Shore D hardness) of approximately 96.

14. A keyboard according to any preceding claim, wherein the crystal (24) is of a mixture of lead zirconate and lead titanate.

15. A keyboard according to any preceding claim, wherein there is provided means (44) operatively coupled to the second surface of the crystal (24) to convert the signals from the crystal to electrical signals having an impedance less than that provided by the crystal (24).

16. A keyboard according to claim 15, wherein the converting means includes a semi-conductor device associated with the crystal (24) and has conductive and non-conductive states and is responsive to the signal from the crystal (24).

17. A keyboard according to claim 16, wherein the semi-conductor device is a field effect transistor.

18. A keyboard having a housing (12), a plurality of particular areas (14) each having associated thin sheets of electrically insulating material (18), electrically conductive member (20), and crystal (24) according to any one of claims 2—17 and being adhered to the housing (12), without voids, in spaced relationship to one another and a plurality of converting means each operatively coupled to the second surface of a respective crystal.

**Patentansprüche**

1. Tastatur mit
einem Gehäuse (12);
einem in nächster Nähe des Gehäuses (12) angeordneten, dünnen Blatt aus elektrisch isolierendem Material (18);
einem an dem dünnen Blatt aus elektrisch isolierendem Material (18) haftenden dünnen Blatt aus einem elektrisch leitfähigen Material (20); und
einem keramischen Kristall (24), der an dem dünnen Blatt aus dem elektrisch leitenden material (20) angebracht und elektrisch leitend mit ihm verbunden ist und der so ausgebildet ist, daß er bei einer Beanspruchung verformbar und geeignet ist, dabei ein elektrisches Signal zu erzeugen, dadurch gekennzeichnet, daß das Gehäuse (12) so ausgebildet ist, daß es einen bestimmten Bereich (14) definiert, der zum Identifizieren eines einzelnen Zeichens eindrückbar ist, daß das dünne Blatt aus dem elektrisch isolierenden Material (18) an dem Gehäuse (12) mit einem harten, elektrisch isolierenden Material (16) an einer Stelle angeklebt, die dem bestimmten Bereich (14) des Gehäuses entspricht, daß das dünne Blatt aus dem elektrisch isolierenden Material (18) so ausgebildet ist, daß es Verformungen überträgt, die in dem Gehäuse (12) durch das Eindrücken des bestimmten Bereichs (14) in dem Gehäuse herbeigeführt werden, daß das dünne Blatt aus dem elektrisch leitenden Material (20) an dem dünnen Blatt aus dem elektrish isolierendem Material (18) an einer Stelle haftet, die dem bestimmten Bereich (14) in dem Gehäuse (12) entspricht, und daß das dünne Blatt aus dem elektrisch leitenden Material (20) so ausgebildet ist, daß es Verformungen überträgt, die in dem Gehäuse (12) durch das Eindrücken des Gehäuses (12) in dem bestimmten Bereich (14) in dem Gehäuse herbeigeführt werden.

2. Tastatur nach Anspruch 1, dadurch gekennzeichnet, daß der keramische Kristall (24) eine der ersten Fläche entgegengesetzte, zweite Fläche besitzt und daß
eine Einrichtung (26) vorgesehen ist, die eine elektrische Verbindung mit der zweiten Fläche des Kristalls herstellt und dazu dient, die von der zweiten Fläche des Kristalls (24) kommenden Signale zu empfangen.

3. Tastatur nach Anspruch 1 oder 2, dadurch gekennzeichnet, daß
das Gehäuse (12) elektrisch leitfähig ist und
eine die Masseebene definierende Einrichtung (22) an dem Gehäuse (12) angebracht ist, so daß die Masseebene an dem Gehäuse geerdet ist.

4. Tastatur nach einem der vorhergehenden Ansprüche, dadurch gekennzeichnet, daß der Kristall eine der ersten Fläche entgegengesetzte, erdfreie zweite Fläche hat, und daß
auf der zweiten Fläche des Kristalls ein isolierender Überzug vorgesehen ist.

5. Tastatur nach einem der vorhergehenden Ansprüche, dadurch gekennzeichnet, daß das dünne Blatt aus dem elektrisch isolierenden Material (18) und das dünne Blatt aus dem elektrisch leitfähigen Material (20) eine gedruckte Schaltung bilden.

6. Tastatur nach einem der vorhergehenden Ansprüche, dadurch gekennzeichnet, daß das dünne Blatt aus dem elektrisch isolierenden Material (18) näher bei dem Gehäuse (12) angeordnet ist als das dünne Blatt aus dem elektrisch leitenden Material (20) und auch näher bei dem Gehäuse (12) angeordnet ist als der Kristall (24).

7. Tastatur nach einem der vorhergehenden Ansprüche, dadurch gekennzeichnet, daß das harte elektrisch isolierende Material (16) eine Durometerhärte (Shore D-Härte) von mindestens 70 hat.

8. Tastatur nach einem der vorhergehenden Ansprüche, dadurch gekennzeichnet, daß das harte elektrisch isolierende Material (16) aus einem Epoxidharz mit zum Vermeiden der Bildung von Hohlräumen beigemischten Füllstoffteilchen besteht.

9. Tastatur nach einem der vorhergehenden Ansprüche, dadurch gekennzeichnet, daß das dünne Blatt aus dem elektrisch leitfähigen Material (20) mit der ersten Fläche des Kristalls durch einen Epoxidharz-Klebstoff verklebt ist, der zum elektrischen Erden der ersten Fläche des Kristalls Teilchen aus einem elektrisch leitenden Material enthält.

10. Tastatur nach einem der vorhergehenden Ansprüche, dadurch gekennzeichnet, daß das Gehäuse (12), das harte elektrisch isolierende Material (16), das dünne Blatt aus dem elektrisch isolierenden Material (18), das dünne Blatt aus dem elektrisch leitfähigen Material (20) und der Kristall (24) ohne jegliche Hohlräume aneinanderliegen.

11. Tastatur nach einem der vorhergehenden Ansprüche, dadurch gekennzeichnet, daß an der zweiten Fläche des Kristalls eine isolierende Abdeckung (32) haftet.

12. Tastatur nach Anspruch 11, dadurch gekennzeichnet, daß die isolierende Abdeckung (32) eine Durometerhärte (Shore D-Härte) von etwa 90 hat.

13. Tastatur nach einem der vorhergehenden Ansprüche, dadurch gekennzeichnet, daß das harte Isoliermaterial (18) eine Durometerhärte (Shore D-Härte) von etwa 96 hat.

14. Tastatur nach einem der vorhergehenden Ansprüche, dadurch gekennzeichnet, daß der Kristall (24) aus einem Gemisch aus Bleizirkonat und Bleititanat besteht.

15. Tastatur nach einem der vorhergehenden Ansprüche, dadurch gekennzeichnet, daß an die zweite Fläche des Kristalls (24) eine Einrichtung zum Umwandeln der von dem Kristall kommenden Signale in elektrische Signale angekoppelt ist, die eine kleinere Impedanz hat als der Kristall.

16. Tastatur nach Anspruch 15, dadurch gekennzeichnet, daß der Wandler eine dem Kristall (24) zugeordnete Halbleitereinrichtung umfaßt, die einen leitenden und einen nichtleitenden Zustand einnehmennkann und auf das von dem Kristall (24) kommende Signal anspricht.

17. Tastatur nach Anspruch 16, dadurch gekennzeichnet, daß die Halbleitereinrichtung ein Feldeffekttransistor ist.

18. Tastatur mit einem Gehäuse (12) mit einer Mehrzahl von bestimmten Bereichen (14), denen je ein Satz nach einem der Ansprüche 2 bis 17 zugeordnet ist, der ein dünnes Blatt aus einem elektrisch isolierenden Material (18), ein dünnes Blatt aus einem elektrisch leitenden Element (20) sowie ein Kristall (24) aufweist, wobei diese Sätze im Abstand voneinander hohlraumfrei an dem Gehäuse (12) haften, sowie mit einer Mehrzahl von Wandlern, die an die zweite Fläche je eines der Kristalle angekoppelt sind.

**Revendications**

1. Clavier comprenant:
un boîtier (12);
une mince feuille d'un matériau électriquement isolant (18) disposée au voisinage du boîtier (12);
une mince feuille d'un élément électriquement conducteur (20) collée à la mince feuille de matériau électriquement isolant (18); et
un cristal de céramique (24) dont la première surface est fixée à la feuille mince de l'élément électriquement conducteur (20), en relation de conduction électrique avec l'élément (20), et qui est construit de façon à subir des déformations et à produire un signal électrique lorsqu'il est déformé, et
caractérisé en ce que le boîtier (12) est construit de manière à définir une zone particulière (14) pouvant être pour identifier un indice particulier, la feuille mince du matériau électriquement isolant (18) est collée au boîtier (12) par un materiau dur électriquement isolant (16) en une position correspondant à la zone particulière (14) du boîtier (12) et construite pour transmettre les déformations produites dans le boîtier (12) par l'enfoncement de la zone particulière (14) du boîtier (12), et en ce que la feuille mince de l'élément électriquement conducteur (20) est collée à la feuille mince de matériau électriquement isolant (18) en une position correspondant à la zone particulière (14) du boîtier (12) et construite pour transmettre les déformations produites dans le boîtier (12) par l'enfoncement du boîtier (12) au niveau de la zone particulière (14) du boîtier.

2. Clavier selon la revendication 1, où le cristal de céramique (24) possède une deuxième surface opposée à la première surface, et où il y a un moyen (26) fournissant une connexion électrique avec la deuxième surface du cristal afin de recevoir les signaux électriques présents sur la deuxième surface du cristal (24).

3. Clavier selon la revendication 1 ou 2, où le boîtier (12) est électriquement conducteur, et où il est prévu un moyen (22) définissant le plan de terre fixé au boîtier (12) pour mettre à la terre le plan de terre par rapport au boîtier.

4. Clavier selon l'une quelconque des revendications précédentes, où le cristal une deuxième surface opposée à la première surface, la deuxième surface du cristal n'étant pas mise à la terre, et où il existe un revêtement isolant au-dessus de la deuxième surface du cristal.

5. Clavier selon l'une quelconque des revendications précédentes, où la feuille mince du matériau électriquement isolant (18) et la feuille mince de l'élément électriquement conducteur (20) constituent un circuit imprimé.

6. Clavier selon l'une quelconque des revendications précédentes, où la feuille mince de matériau électriquement isolant (18) est disposée plus près du boîtier (12) que la feuille mince de matériau électriquement conducteur (20) et est disposée même plus près du boîtier (12) que le cristal (24).

7. Clavier selon l'une quelconque des revendications précédentes, où le matériau dur électriquement isolant (16) possède une valeur de dureté (dureté Shore D) d'au moins 70.

8. Clavier selon l'une quelconque des revendications précédentes, où le matériau dur électriquement isolant (16) est formé d'un époxy mélangé avec des particules d'une charge afin d'empêcher la formation de vides.

9. Clavier selon l'une quelconque des revendications précédentes, où un adhésif d'époxy colle la feuille mince de l'élément électriquement conducteur (20) à la première face du cristal et comporte des particules d'un matériau électriquement conducteur pour connecter électriquement à la terre la première surface du cristal.

10. Clavier selon l'une quelconque des revendications précédentes, où le boîtier (12), le matériau dur électriquement isolant (16), la feuille mince de matériau électriquement isolant (18), la feuille mince de l'élément électriquement conducteur (20) et le cristal (24) sont disposés en relation d'appui les uns sur les autres sans aucun vide.

11. Clavier selon l'une quelconque des revendications précédentes, où un revêtement isolant (32) est collé à la deuxième surface du cristal.

12. Clavier selon la revendication 11, où le revêtement isolant (32) présente une valeur de dureté (dureté Shore D) d'environ 90.

13. Clavier selon l'une quelconque des revendications précédentes, ou le matériau isolant (18) possède une valeur de dureté (dureté Shore D) d'environ 96.

14. Clavier selon l'une quelconque des revendications précédentes, où les cristal (24) est fait d'un mélange de zirconate de plomb et de titanate de plomb.

15. Clavier selon l'une quelconque des revendications précédentes, où il est prévu un moyen (44) fonctionnellement couplé à la deuxième surface du cristal (24) pour convertir les signaux venant du cristal en signaux électriques avec une impédance inférieure à celle fournie par le cristal (24).

16. Clavier selon la revendication 15, où le moyen convertisseur comporte un dispositif semiconducteur associé au cristal (24) et possède des états de conduction et de non-conduction, ce moyen étant sensible au signal qui vient du cristal (24).

17. Clavier selon la revendication 16, où le dispositif semiconductor est un transistor à effet de champ.

18. Clavier possédant un boîtier (12), plusieurs zones particulières (14) qui sont chacune associées à de minces feuilles de matériau électriquement isolant (18), d'élément électriquement conducteur (20) et de cristal (24) selon l'une quelconque des revendications 2 à 17 et sont collées au boîtier (12), sans vides, en relation d'écartement les unes par rapport aux autres et plusieurs moyens convertisseurs qui sont chacun fonctionnellement couplés à la deuxième surface d'un cristal respectif.

FIG.1

14

1 2 3
4 5 6
7 8 9
* 0 #

10 12 14

FIG.3

26

16

32

18
20

26

18
20

30

26

28 30 24

10

FIG.2

32

22

18,20 10

22

26

18,20

22

24

24

26

26

26

32

16

12

16

18

20

24

22

26

FIG.4

Fig.5

VOLTAGE
SOURCE ⟋—54

Fig. 6